(19) **Europäisches Patentamt**

**European Patent Office**

**Office européen des brevets**

(11) **EP 1 156 590 A1**

(12) **EUROPEAN PATENT APPLICATION**
published in accordance with Art. 158(3) EPC

(43) Date of publication:
 **21.11.2001 Bulletin 2001/47**

(51) Int Cl.⁷: **H04B 1/16**, H04B 7/26

(21) Application number: **00981833.7**

(86) International application number:
 **PCT/JP00/09002**

(22) Date of filing: **19.12.2000**

(87) International publication number:
 **WO 01/48933 (05.07.2001 Gazette 2001/27)**

(84) Designated Contracting States:
 **AT BE CH CY DE DK ES FI FR GB GR IE IT LI LU MC NL PT SE TR**
 Designated Extension States:
 **AL LT LV MK RO SI**

(30) Priority: **28.12.1999 JP 37526299**

(71) Applicant: **MATSUSHITA ELECTRIC INDUSTRIAL CO., LTD.**
 **Kadoma-shi, Osaka 571-8501 (JP)**

(72) Inventors:
 • **TAKAHASHI, Hideyuki**
  **Yokosuka-shi, Kanagawa 239-0841 (JP)**
 • **KITADE, Takashi**
  **Yokosuka-shi, Kanagawa 239-0847 (JP)**

(74) Representative: **Grünecker, Kinkeldey, Stockmair & Schwanhäusser Anwaltssozietät**
 **Maximilianstrasse 58**
 **80538 München (DE)**

(54) **RECEIVER AND GAIN CONTROL METHOD**

(57) A SINR measuring section 108 measures a ratio between a desired signal and an interference signal based on an output signal of an A/D converter 104 and an output signal of an interference canceller 108. An absolute electric field intensity calculator 111 calculates absolute electric field intensity of a desired signal based on said ratio between the desired signal and the interference signal and electric field intensity of said received signal. A determination section 112 determines the relationship between absolute electric field intensity of said desired signal and a preset target object in terms of the valve large and small. A gain coefficient calculator 113 calculates a gain coefficient based on the determination result of the determination section 112, and controls a gain of an AGC section 103. This makes it possible to perform AGC accurately and to prevent deterioration of reception quality.

FIG. 6

EP 1 156 590 A1

**Description**

Technical Field

The present invention relates to a receiving apparatus, which is used in a digital radio communication system such as a cellular phone, a car phone, and the like, and relates to a gain controlling method.

Background Art

In a digital radio communication system such as a cellular phone, a car phone, and the like, which have recently been increased in demand, a base station provided for each cell assigns a radio channel to each of a plurality of communication terminals being present in the cell, and performs radio communication therewith concurrently.

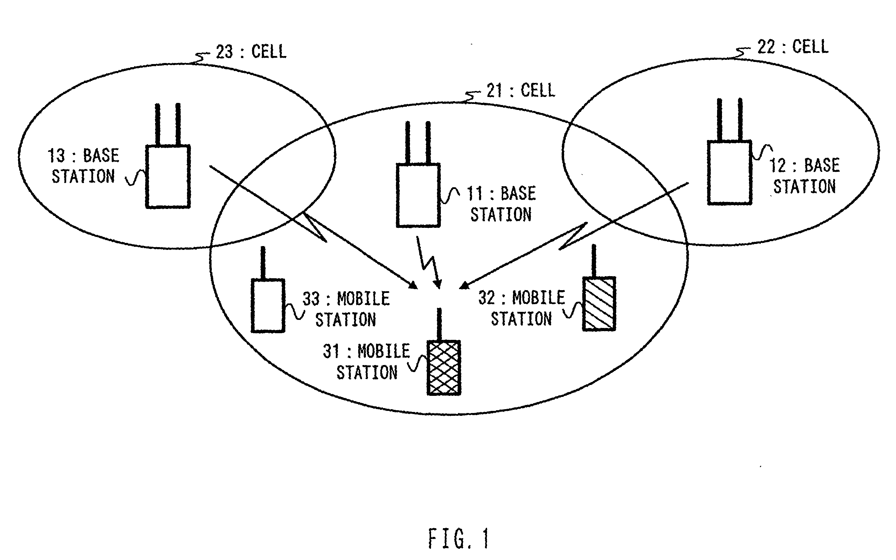

FIG. 1 is a view illustrating the configuration of the digital radio communication system. In FIG. 1, it is assumed that a base station 11, a base station 12, and a base station 13 are provided in a cell 21, a cell 22, and a cell 23, respectively. It is also assumed that mobile stations 31, 32, and 33 are present in the current cell 21, and perform radio communication with the base station 11, respectively.

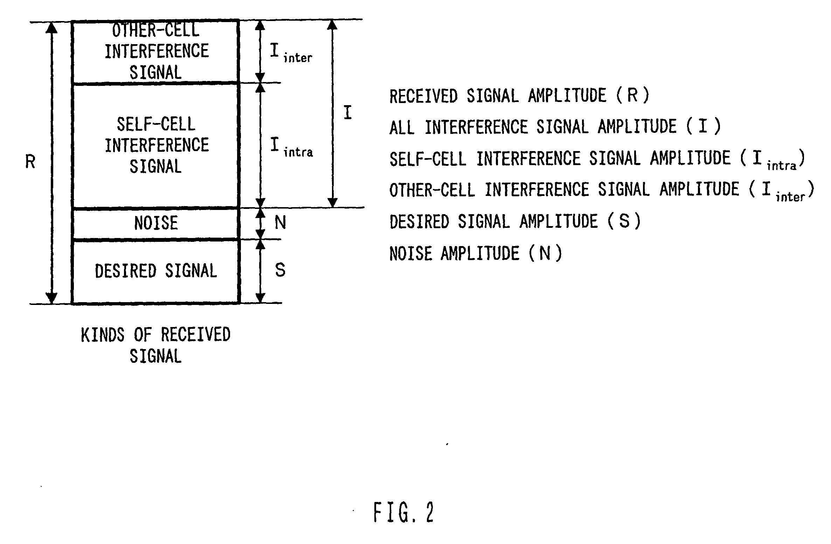

FIG. 2 is a view illustrating kinds of signals received by the mobile station 31 of FIG. 1. As illustrated in FIG. 2, a signal, which is transmitted from the base station 11, is a desired signal S to the mobile station 31 that performs radio communication with the base station 11. However, when a signal S is received by the mobile station 31, noise N is included in the received signal S.

Other than noise N, the received signal R includes a self-cell interference signal $I_{intra}$, which is transmitted to the mobile stations 32 and 33 other than those of the self-cell from the base station 11 and other-cell interference signal $I_{inter}$, which is transmitted from the base stations 12 and 13, as an interference signal I.

A receiving apparatus installed in the mobile station 31 provides automatic gain control (hereinafter referred to as "AGC") to the received signal, and converts the resultant signal to a digital signal, and modulates a desired signal included in the received signal to extract received data. In addition, AGC is control that is performed to set electric field intensity of the received signal to a preset target value for the purpose of improving accuracy at the time of converting the received signal digitally.

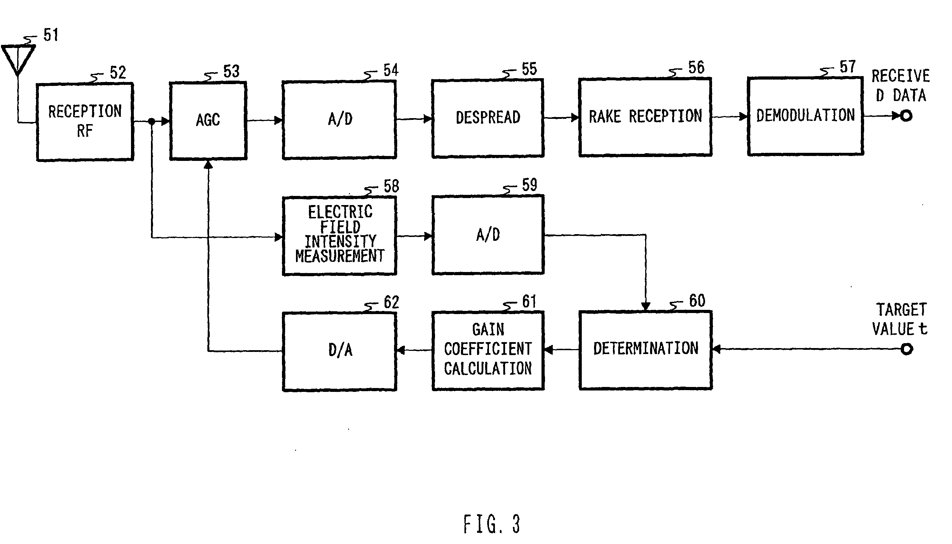

The following will explain the configuration of the conventional receiving apparatus installed in the mobile station with reference to the block diagram of FIG. 3.

In the receiving apparatus of FIG. 3, a reception RF section 52 amplifies a radio frequency signal received by an antenna 51 and frequency-converts the amplified signal to a baseband signal. An AGC section 53 controls again of the baseband signal outputted from the reception RF section 52 in accordance with a gain coefficient. An A/D converter 54 converts an output signal of the AGC section 53 to a digital signal.

A despreader 55 multiplies the output signal of the A/D converter 54 by the same spread code as used in the transmitting side. A RAKE receiver 56 RAKE combines the output signal of the despreader 55. A demodulator 57 demodulates the output signal of the RAKE receiver 56 to extract received data.

An electric field intensity measuring section 58 measures electric field intensity of the baseband signal outputted from the reception RF section 52. Additionally, electric field intensity is obtained by placing an antenna whose effective length is sure in the electric field to measure voltage induced by this antenna.

An A/D converter 59 converts the measurement result of electric filed intensity measured by the electric field intensity measuring section 58 to a digital signal, and outputs absolute electric field intensity $(S+I+N)_{abs}$ of the received signal.

A determination section 60 determines the relationship between absolute electric field intensity $(S+I+N)_{abs}$ of the received signal outputted from the A/D converter 59 and a target value t in terms of the value of large or small. Additionally, signal amplitude X (hereinafter referred to as "amplitude X" ) that can be expressed by bits is used as a target value t.

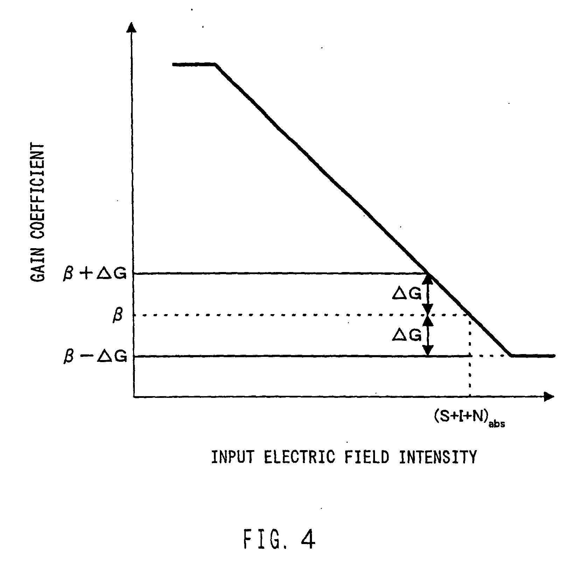

A gain coefficient calculator 61 outputs a value ($\beta+\Delta G$ or $\beta-\Delta G$), serving as a new gain coefficient, obtained by adding/subtracting a corrected value of AGC gain coefficient (hereinafter simply referred to as "gain corrected value") $\Delta G$ to/from a previous gain coefficient $\beta$ based on the determination result of the determination section 60 as in the relationship between the input electric field intensity and the gain coefficient of FIG. 4.

More specifically, in the case where the absolute electric field intensity $(S+I+N)_{abs}$ of the received signal is more than the target value t, the gain coefficient calculator 61 adds the gain corrected value $\Delta G$ to the previous gain coefficient $\beta$. In the other cases, the gain coefficient calculator 61 subtracts the gain corrected value $\Delta G$ from the previous gain coefficient $\beta$. Additionally, the gain corrected value $\Delta G$ is a value that is preset.

A D/A converter 62 converts the gain coefficient calculated by the gain coefficient calculator 61 to an analog value and outputs the resultant to the AGC section 53.

Hence, the conventional receiving apparatus aims to improve accuracy when the received signal is converted to the digital signal by AGC that performs closed loop control.

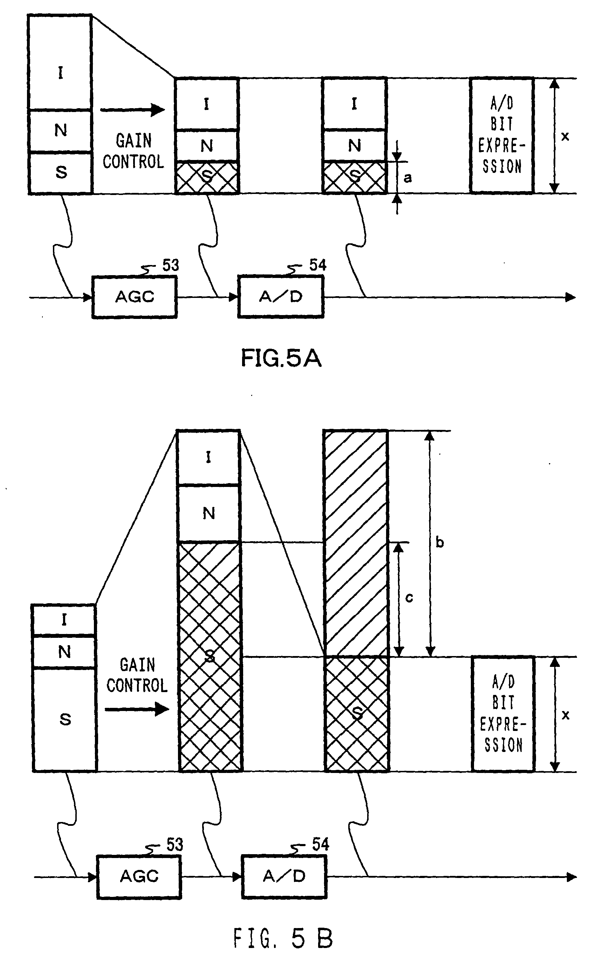

According to the conventional receiving apparatus, however, as in the signal components of FIG. 5A, in the case where the percentage of the interference signal I and noise N, which are included in the received signal R, becomes large, bit accuracy (direction a in a vertical axial direction) of the desired signal S becomes insufficient, causing deterioration of reception quality.

While, as in the signal components of FIG. 5B, allowing for the amounts of interference signal I and noise N to improve the bit accuracy of the desired signal S, AGC is performed such that the target value t is set to be larger than amplitude X to perform clipping reception (direction b in a vertical axial direction). As a result, in the case where the percentage of the interference signal I and noise N, which are included in the received signal R, becomes small, even the desired signal S is clipped (direction c in a vertical axial direction), causing deterioration of reception quality. Additionally, clipping is that the peak of the signal and that of the linguistic syllable are clipped to the extent that they can be sensed.

Namely, the conventional receiving apparatus calculates the gain coefficient based on electric field intensity of the received signal without allowing for the percentage of the desired signal included in the received signal, and this causes a problem in which AGC cannot be accurately performed to deteriorate reception quality.

Disclosure of Invention

In is an object of the present invention is to provide a receiving apparatus, which is capable of performing AGC accurately to make it possible to prevent reception quality from being deteriorated, and to provide a gain controlling method.

This object can be attained by such a way that electric field intensity of a signal where an interference signal is removed from a received signal is obtained by a ratio between a desired signal and an interference signal and reception electric field intensity to calculate a gain coefficient based on this electric field intensity.

Brief Description of Drawings

FIG. 1 is a view illustrating the configuration of the digital radio communication system;

FIG. 2 is a view illustrating the kinds of a signal received by a mobile station of FIG. 1;

FIG. 3 is a block diagram illustrating the configuration of a conventional receiving apparatus;

FIG. 4 is a view illustrating the relationship between input electric field intensity and a gain coefficient in the conventional receiving apparatus;

FIG. 5A is a view illustrating signal components before and after AGC and A/D conversion in the conventional receiving apparatus;

FIG. 5B is a view illustrating signal components before and after AGC and A/D conversion in the conventional receiving apparatus;

FIG. 6 is a block diagram illustrating the configuration of a receiving apparatus according to Embodiment 1 of the present invention;

FIG. 7 is a view illustrating the relationship between input electric field intensity and a gain coefficient according to Embodiment 1 of the present invention;

FIG. 8A is a view illustrating signal components before and after AGC and A/D conversion in the receiving apparatus according to Embodiment 1 of the present invention;

FIG. 8B is a view illustrating signal components before and after AGC and A/D conversion in the receiving apparatus according to Embodiment 1 of the present invention;

FIG. 9 is a block diagram illustrating the configuration of a receiving apparatus according to Embodiment 2 of the present invention;

FIG. 10 is a view illustrating the relationship between input electric field intensity and a gain coefficient in the receiving apparatus according to Embodiment 2 of the present invention;

FIG. 11A is a view illustrating signal components before and after AGC and A/D conversion in the receiving apparatus according to Embodiment 2 of the present invention; and

FIG. 11B is a view illustrating signal components before and after AGC and A/D conversion in the receiving apparatus according to Embodiment 2 of the present invention.

Best Mode for Carrying Out the Invention

The following will specifically explain embodiments of the present invention with reference to the drawings accompanying herewith.

(Embodiment 1)

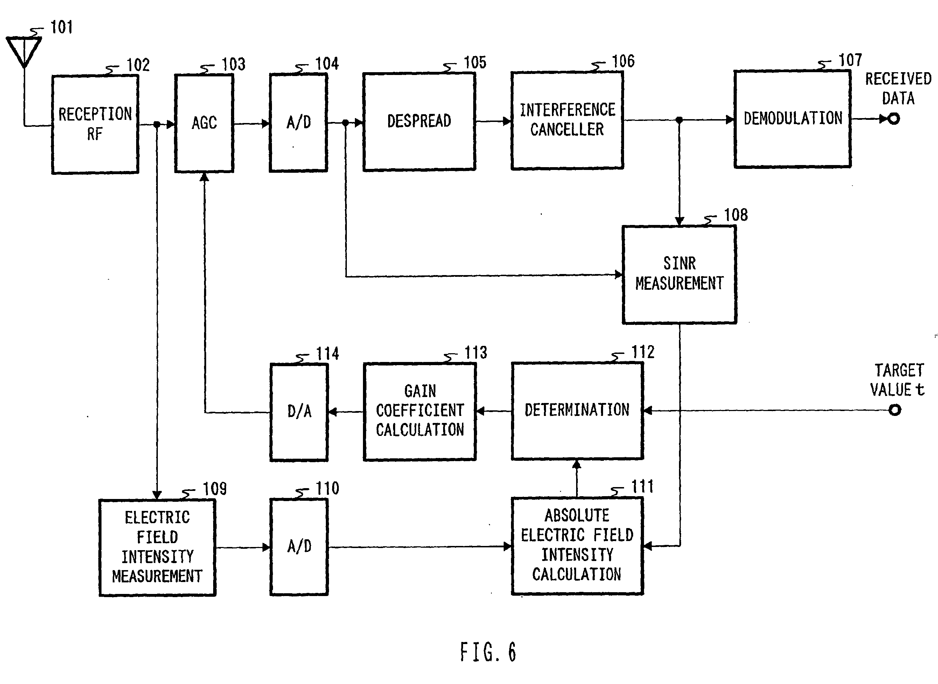

FIG. 6 is a block diagram illustrating the configuration of a receiving apparatus according to Embodiment 1 of the present invention.

In the receiving apparatus of FIG. 6, a reception RF section 102 amplifies a radio frequency signal received by an antenna 101, and frequency-converts the amplified signal to a baseband signal. An AGC section 103 controls a gain of the baseband signal outputted from the reception RF section 102 in accordance with a gain coefficient inputted from a D/A converter 114 to be described later. An A/D converter 104 converts the output signal of the AGC section 103 to a digital signal.

A despreader 105 multiplies the output signal of the A/D converter 104 by the same spread code as used in the transmitting side. An interference canceller 106 removes an interference signal I from the output signal of the despreader 105. Additionally, the interference canceller 106 cannot remove noise N from the output signal of the output signal 105.

A demodulator 107 demodulates the output signal of the interference canceller 106 to extract received data.

An SINR measuring section 108 measures SINR from the output signal of the A/D converter 104 and the output signal of the interference canceller 106 based on the following equation (1)

$$SINR = \frac{\sum |S|}{\sum |(S+I+N)\text{-}S|} \tag{1}$$

An electric field intensity measuring section 109 measures electric field intensity of the baseband signal outputted from the reception RF section 102. In addition, electric field intensity can be obtained by placing an antenna whose effective length is sure in the electric field to measure voltage induced by this antenna.

An A/D converter 110 converts the measurement result of electric field intensity measured by the electric field intensity measuring section 109 to a digital signal, and outputs absolute electric field intensity $(S+I+N)_{abs}$ of the received signal.

An absolute electric filed intensity calculator 111 calculates absolute electric field intensity $(S+N)_{abs}$ of a desired signal S from SINR and absolute electric field intensity $(S+I+N)_{abs}$ of the received signal based on equation (2) set forth below. Additionally, the reason why noise N is left in absolute electric field intensity $(S+N)_{abs}$ of the desired signal S is that noise N cannot be removed by the interference canceller 106.

$$(S+N)_{abs} = (S+N+I)_{abs} \cdot \exp\left(\frac{SINR}{20}\right) \tag{2}$$

A determination section 112 determines the relationship between absolute electric field intensity $(S+N)_{abs}$ of the desired signal S outputted from the absolute electric filed intensity calculator 111 and a target value t in terms of the value of large or small.

A gain coefficient calculator 113 outputs a value ($\alpha+\Delta G$ or $\alpha-\Delta G$), serving as a new gain coefficient, obtained by adding/subtracting a gain corrected value $\Delta G$ to/from a previous gain coefficient $\alpha$ based on the determination result of the determination section 112.

More specifically, in the case where absolute electric field intensity $(S+N)_{abs}$ of the desired signal S is more than the target object t, the gain corrected gain $\Delta G$ is added to the previous gain coefficient $\alpha$ such that the desired signal S is not clipped. While, in the case where absolute electric field intensity $(S+N)_{abs}$ of the desired signal S is less than the target object t, the gain corrected gain $\triangle G$ is subtracted from the previous gain coefficient $\alpha$ to improve bit accuracy of the desired signal S.

A D/A converter 114 converts the gain coefficient outputted from the gain coefficient calculator 113 to an analog value, and outputs the resultant to the AGC section 103.

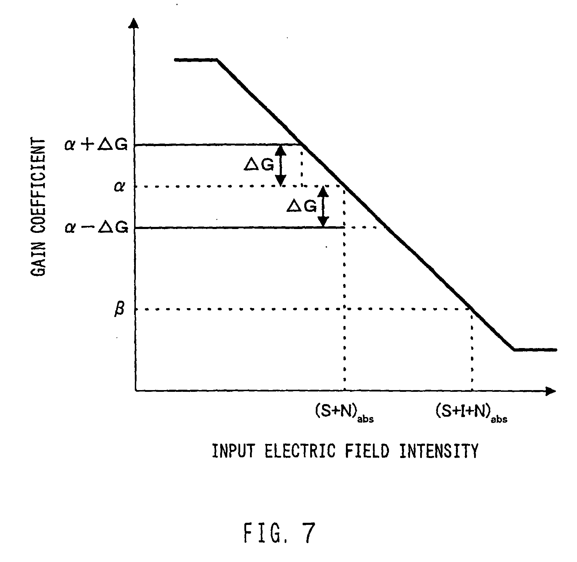

Accordingly, as illustrated in FIG. 7, the use of the output signal of the interference canceller makes it possible to calculate the gain coefficient based on absolute electric field intensity $(S+N)_{abs}$ of the desired signal S as compared with the conventional case in which the gain coefficient is calculated based on absolute electric field intensity $(S+I+N)_{abs}$ of the received signal.

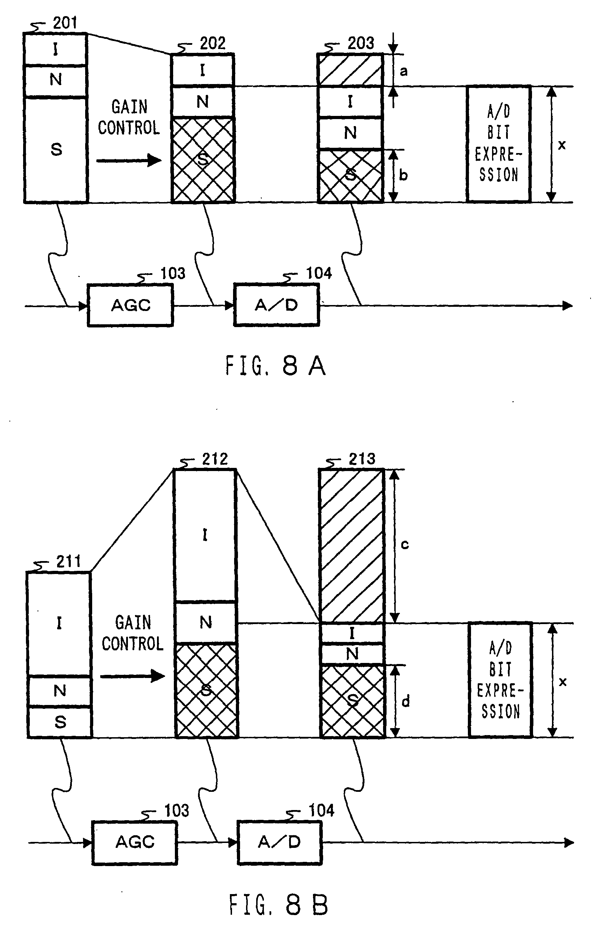

FIG. 8A and FIG. 8B are views each illustrating signal components before and after AGC and A/D conversion in the receiving apparatus according to Embodiment 1 of the present invention. Then, FIG. 8A indicates a case in which absolute electric field intensity $(S+N)_{abs}$ of the desired signal S is more than the target object t, and FIG. 8B indicates a case in which absolute electric field intensity $(S+N)_{abs}$ of the desired signal S is less than the target object t.

In the case of FIG. 8A, electric field intensity of a received signal 201 is reduced by the AGC section 103 such that the desired signal S is not be clipped. The output signal 202 of the AGC section 103 is converted to a digital signal by the A/D converter 104. At this time, the interference signal I and a part of noise N are clipped (distance a in a vertical axial direction).

Then, the desired signal S included in the output signal 203 of the A/D converter 104 is not clipped and has sufficient bit accuracy (distance b in a vertical axial direction), with the result that reception quality is not deteriorated.

While, in the case of FIG. 8B, electric field intensity of a received signal 211 is increased by the AGC section 103 in order to increase bit accuracy of the desired signal S. An output signal 212 of the AGC section 103 is converted to a digital signal by the A/D converter 104. At this time, the interference signal I and a part of noise N are clipped (distance c in a vertical axial direction).

Then, the desired signal S included in an output signal 213 of the A/D converter 104 is not clipped and has sufficient bit accuracy (distance d in a vertical axial direction), with the result that reception quality is not deteriorated.

In this way, the gain coefficient is calculated based on electric field intensity of the signal where the interference signal is removed from the received signal, whereby making it possible to perform AGC accurately and to prevent the deterioration of reception quality.

In this receiving apparatus of this embodiment, a SUD (Single User Detection) type interference canceller can be used as an interference canceller.

(Embodiment 2)

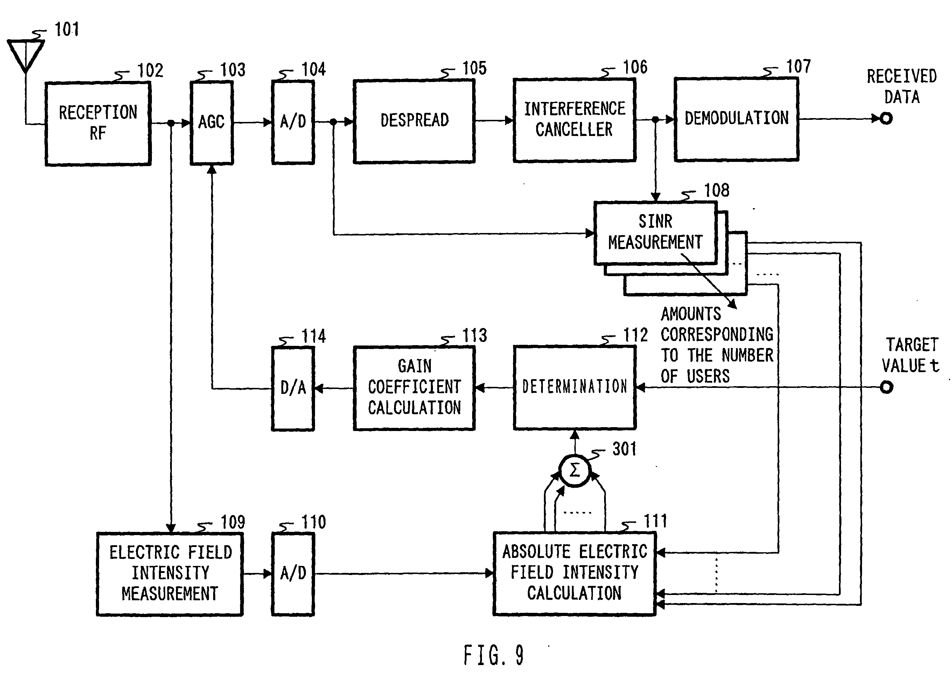

FIG. 9 is a block diagram illustrating the configuration of a receiving apparatus according to Embodiment 2 of the present invention. In the receiving apparatus of FIG. 9, the same reference numerals as those of the receiving apparatus of FIG. 6 are added to the portions common to FIG. 6, and explanation is omitted.

As compared with the receiving apparatus of FIG. 6, the receiving apparatus of FIG. 9 adopts a configuration in which the number of SINR measuring sections 108 corresponding to the number of users is provided and an adder 301 is added.

Herein, in the explanation set forth below, it is assumed that a desired signal of user k is $S_k$ and an interference signal with respect to user k is $I_k$, and noise with respect to the user k is set to $N_k$.

Each SINR measuring section 108 measures SINR of the corresponding user k in its cell from an output signal $(S_k+I_k+N_k)$ of the A/D converter 104 and the desired signal $S_k$ outputted from the interference canceller 106 based on equation (3) set forth below.

$$SINR_k = \frac{\sum |S_k|}{\sum |(S_k + I_k + N_k) - S_k|} \qquad (3)$$

The electric field intensity measuring section 109 measures electric field intensity of the baseband signal outputted from the reception RF section 102 on a user-by-user basis. The A/D converter 110 converts the measurement result of electric field intensity of each user measured by the electric field intensity measuring section 109 to a digital signal, and outputs absolute electric field intensity $(S_k+I_k+N_k)_{abs}$ of the received signal for each user.

The absolute electric filed intensity calculator 111 calculates absolute electric field intensity $(S_k+N_k)_{abs}$ of a desired signal $S_k$ of each user from SINR for each user and absolute electric field intensity $(S_k+I_k+N_k)_{abs}$ of the received signal for each user based on equation (4) set forth below.

$$(S_k + N_k)_{abs} = (S + N + I)_{abs} \cdot \exp\left(\frac{SINR_k}{20}\right) \qquad (4)$$

An adder 301 adds all $(S_k+N_k)_{abs}$ of the desired signals $S_k$ of the respective users in its cell calculated by the absolute electric filed intensity calculator 111 as shown in the following equation (5), and outputs a total value $\Sigma(S+N)_{abs}$, which is the addition result.

$$\sum (S+N)_{abs} = \sum_{i=0}^{k-1} (S_i + N_i)_{abs} \qquad\qquad (5)$$

The determination section 112 determines the relationship between the total $\Sigma$ $(S+N)_{abs}$ of absolute electric field intensity of the desired signal $S_k$ outputted from the adder 301 and a target value t in terms of the value of large or small.

The gain coefficient calculator 113 outputs a value ($\gamma+\Delta G$ or $\gamma-\Delta G$), serving as a new gain coefficient, obtained by adding/subtracting a gain corrected value $\Delta$ G to/from a previous gain coefficient $\gamma$ based on the determination result of the determination section 112.

More specifically, in the case where the total $\Sigma$ $(S+N)_{abs}$ of absolute electric field intensity of the desired signal $S_k$ is more than the target object t, the gain corrected gain$\Delta G$ is added to the previous gain coefficient $\gamma$ such that the desired signals of all users in its cell are not clipped. While, in the case where the total $\Sigma$ $(S+N)_{abs}$ of absolute electric field intensity of the desired signal $S_k$ is less than the target object t, the gain corrected gain$\Delta G$ is subtracted from the previous gain coefficient $\gamma$ in order to improve bit accuracy of the desired signals S of all users in its cell.

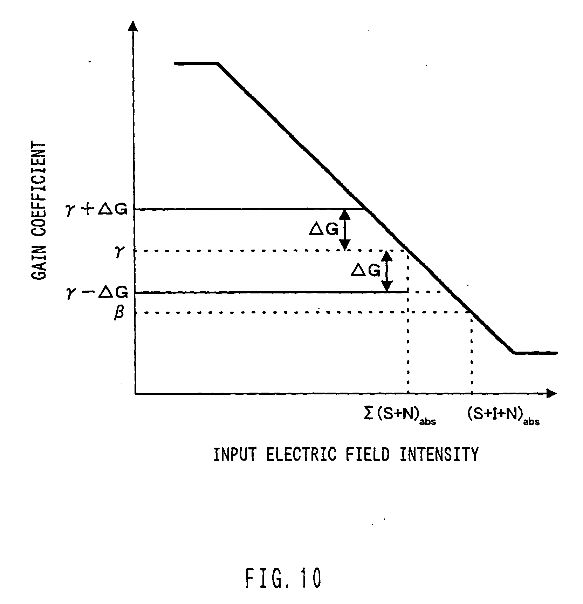

Accordingly, as illustrated in FIG. 10, the use of the output signal of the interference canceller for each user makes it possible to calculate the gain coefficient based on the total value $\Sigma$ $(S+N)_{abs}$ of absolute electric field intensity of the desired signal $S_k$ as compared with the conventional case in which the gain coefficient is calculated based on absolute electric field intensity (S+ N)$_{abs}$ of the received signal.

Herein, as mentioned above, the interference signal I is divided into the self-cell interference signal $I_{intra}$, and other-cell interference signal $I_{inter}$. Since a desired signal other than the desired signal of the corresponding user is included in the self-cell interference signal $I_{intra}$, the receiving apparatus of the above embodiment performs AGC to clip only the other-cell interference signal $I_{inter}$ without clipping the self-cell interference signal $I_{intra}$.

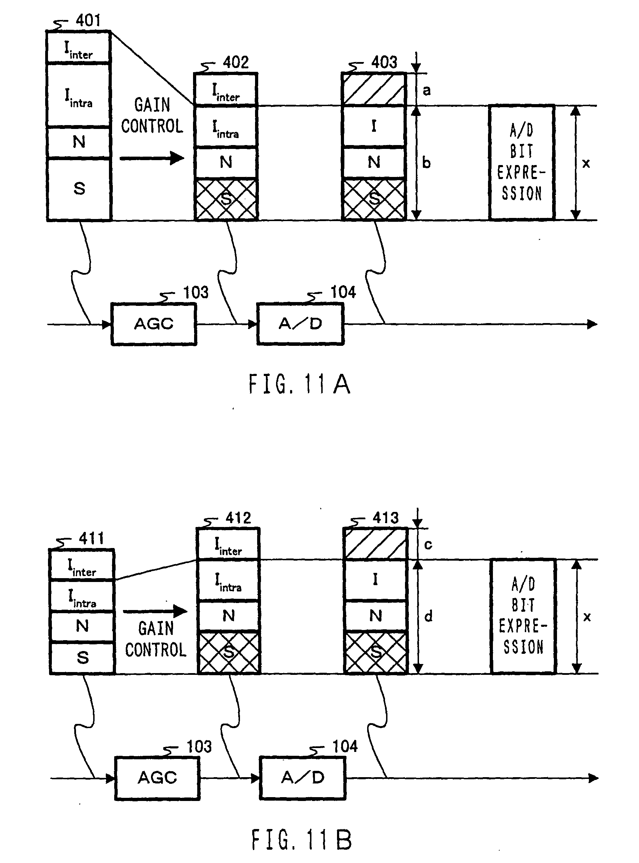

FIG. 11A and FIG. 11B are views each illustrating signal components before and after AGC and A/D conversion in the receiving apparatus according to this embodiment. Then, FIG. 11A indicates a case in which the total value $\Sigma$ $(S+N)_{abs}$ of absolute electric field intensity of the desired signal $S_k$ is more than the target value t, and FIG. 11B indicates a case in which the total value $\Sigma$ $(S+N)_{abs}$ of absolute electric field intensity of the desired signal $S_k$ is less than the target value t.

In the case of FIG. 11A, electric field intensity of a received signal 401 is reduced by the AGC section 103 such that the desired signal S is not clipped. An output signal 402 of the AGC section 103 is converted to a digital signal by the A/D converter 104. At this time, other-cell interference signal $I_{inter}$ is clipped (distance a in a vertical axial direction).

Then, the desired signal S included in the output signal 403 of the A/D converter 104 and other-cell interference signal $I_{inter}$ are not clipped and have sufficient bit accuracy (distance b in a vertical axial direction), with the result that reception quality is not deteriorated.

While, in the case of FIG. 11B, electric field intensity of a received signal 411 is reduced by the AGC section 103 in order to improve bit accuracy of the desired signal S. An output signal 412 of the AGC section 103 is converted to a digital signal by the A/D converter 103. At this time, other-cell interference signal $I_{inter}$ is clipped (distance c in a vertical axial direction).

Then, the desired signal S included in the out put signal 413 of the A/D converter 104 and other-cell interference signal $I_{inter}$ are not clipped and have sufficient bit accuracy (distance d in a vertical axial direction), with the result that reception quality is not deteriorated.

In this way, the gain coefficient is calculated based on electric field intensity of the signal where only the other-cell interference signal $I_{inter}$ is removed from the received signal, whereby making it possible to perform AGC accurately and to prevent the deterioration of reception quality.

In this receiving apparatus of this embodiment, a SUD (Single User Detection) type interference canceller can be used as an interference canceller.

In the aforementioned embodiments, the target value can be suitably set. For example, there is a case in which signal amplitude that can be expressed by bits is used as a target value or a case in which a value that is obtained by subtracting a margin from signal amplitude that can be expressed by bits is used as a target value.

Allowing for the margin makes it possible to prevent the desired signal from being clipped even in the case where variation in a propagation path such as a user at a high-speed moving time is large.

The receiving apparatus of each of the aforementioned embodiments can be mounted on the base station apparatus of the digital radio communication system and the communication terminal apparatus thereof.

As is obvious from the explanation, according to the receiving apparatus and the gain controlling apparatus of the present invention, electric field intensity of a signal where an interference signal is removed from a received' signal is obtained by a ratio between a desired signal and an interference signal and received electric field intensity to calculate a gain coefficient based on this electric field intensity. This makes it possible to perform AGC accurately and to prevent deterioration of reception quality.

This application is based on the Japanese Patent Application No. HEI 11-375262 filed on December 28, 1999, entire content of which is expressly incorporated by reference herein

Industrial Applicability

The present invention is suitable for use in a digital radio communications system such as a digital car phone, a car phone, and the like.

**Claims**

1. A receiving apparatus comprising:

   automatic gain controlling means for providing automatic gain control to a received signal based on a gain coefficient;
   SINR measuring means for measuring a ratio between a desired signal and an interference signal of the signal subjected to automatic gain control;
   electric field intensity measuring means for measuring electric field intensity of the received signal;
   absolute electric field intensity calculating means for calculating absolute electric field intensity of a desired signal based on said ratio between the desired signal and the interference signal and electric field intensity of said received signal; and
   gain coefficient calculating means for calculating a gain coefficient based on the relationship between absolute electric field intensity of the desired signal and a preset target value in terms of the value of large and small.

2. A receiving apparatus comprising:

   automatic gain controlling means for providing automatic gain control to a received signal based on a gain coefficient;
   SINR measuring means for measuring a ratio between a desired signal and an interference signal of each user in a self-cell from the signal subjected to automatic gain control;
   electric field intensity measuring means for measuring electric field intensity of the received signal;
   absolute electric field intensity calculating means for calculating a total value of absolute electric field intensity of desired signals of all users in the self-cell based on said ratio between the desired signal and the interference signal and electric field intensity of said received signal; and
   gain coefficient calculating means for calculating a gain coefficient based on the relationship between a total value and a preset target value in terms of the value of large and small.

3. The receiving apparatus according to claim 1, wherein said gain coefficient calculating means adds a preset corrected value to a previous gain coefficient when absolute electric field intensity of the desired signal is more than the target value, and subtracts said corrected value from said previous gain coefficient when absolute electric field intensity of the desired signal is less than the target value.

4. The receiving apparatus according to claim 1, wherein signal amplitude that can be expressed by bits is set as a target value.

5. The receiving apparatus according to claim 1, wherein a value obtained by subtracting a margin from signal amplitude that can be expressed by bits is set as a target value.

6. A radio communication terminal apparatus having a receiving apparatus therein, said receiving comprising

   automatic gain controlling means for providing automatic gain control to a received signal based on a gain coefficient;
   SINR measuring means for measuring a ratio between a desired signal and an interference signal of the signal subjected to automatic gain control;
   electric field intensity measuring means for measuring electric field intensity of the received signal;
   absolute electric field intensity calculating means for calculating absolute electric field intensity of a desired signal based on said ratio between the desired signal and the interference signal and electric field intensity of said received signal; and
gain coefficient calculating means for calculating a gain coefficient based on the relationship between absolute electric field intensity of the desired signal and a preset target value in terms of the value of large and small.

7.  A gain controlling means comprising the steps of:

providing automatic gain control to a received signal to be converted to a digital signal;
measuring a ratio between a desired signal and an interference signal based on a signal where an interference signal is removed from said digital signal and said digital signal;
calculating absolute electric field intensity of the desired signal based on said ratio between the desired signal and the interference signal and electric field intensity of said received signal; and
calculating a gain coefficient of a next automatic gain control based on the relationship between absolute electric field intensity of said desired signal and a preset target object in terms of the value of large and small.

8.  A gain controlling means comprising the steps of:

providing automatic gain control to a received signal to be converted to a digital signal;
measuring a ratio between a desired signal and an interference signal of each user in a self-cell based on a signal where an interference signal is removed from said digital signal and said digital signal;
calculating a total value of absolute electric field intensity of the desired signals of all users in the self-cell based on said ratio between the desired signal and the interference signal and electric field intensity of said received signal; and
calculating a gain coefficient of a next automatic gain control based on the relationship between said total value and a preset target object in terms of the value of large and small.

9.  The gain controlling method according to claim 7, wherein a preset corrected value is added to a previous gain coefficient when absolute electric field intensity of the desired signal is more than the target value and said preset corrected value is subtracted from said previous gain coefficient when absolute electric field intensity of the desired signal is less than the target value.

FIG. 1

EP 1 156 590 A1

RECEIVED SIGNAL AMPLITUDE ( R )

ALL INTERFERENCE SIGNAL AMPLITUDE ( I )

SELF-CELL INTERFERENCE SIGNAL AMPLITUDE ( $I_{intra}$ )

OTHER-CELL INTERFERENCE SIGNAL AMPLITUDE ( $I_{inter}$ )

DESIRED SIGNAL AMPLITUDE ( S )

NOISE AMPLITUDE ( N )

FIG. 2

FIG. 3

FIG. 4

FIG.5A

FIG. 5 B

FIG. 6

EP 1 156 590 A1

FIG. 7

201

I
N
S

GAIN
CONTROL
→

202

I
N
S

203

I
N
S

a

b

A/D
BIT
EXPRE-
SSION

x

103

AGC

104

A/D

FIG. 8 A

211

I
N
S

GAIN
CONTROL
→

212

I
N
S

213

I
N
S

c

d

A/D
BIT
EXPRE-
SSION

x

103

AGC

104

A/D

FIG. 8 B

FIG. 9

FIG. 10

FIG. 11 A

FIG. 11 B

## INTERNATIONAL SEARCH REPORT

| | International application No. |
|---|---|
| | PCT/JP00/09002 |

**A. CLASSIFICATION OF SUBJECT MATTER**
Int.Cl$^7$  H04B1/16
H04B7/26

According to International Patent Classification (IPC) or to both national classification and IPC

**B. FIELDS SEARCHED**

Minimum documentation searched (classification system followed by classification symbols)
Int.Cl$^7$  H04B1/16
H04B7/26
H03G3/20

Documentation searched other than minimum documentation to the extent that such documents are included in the fields searched
Jitsuyo Shinan Koho        1922-1996    Toroku Jitsuyo Shinan Koho  1994-2001
Kokai Jitsuyo Shinan Koho  1971-2001    Jitsuyo Shinan Toroku Koho  1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y A | JP, 7-52851, B2 (Matsushita Electric Ind. Co., Ltd.), 05 June, 1995 (05.06.95)  (Family: none) | 1,3-6 2,7-9 |
| A | JP, 7-79171, A (NEC IC Microcomput. System Ltd.), 20 March, 1995 (20.03.95)  (Family: none) | 1-9 |
| A | JP, 62-43615, B2 (NEC Corporation, Nippon Telegr. & Teleph. Corp. <NTT>), 16 September, 1987 (16.09.87) & AU, 1272183, A    & EP, 89853, A2 & US, 4525868, A1    & CA, 1196966, A | 1-9 |
| A | JP, 11-340859, A (Kyocera Corporation), 10 December, 1999 (10.12.99)  (Family: none) | 1-9 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 March, 2001 (09.03.01) | 21 March, 2001 (21.03.01) |

| Name and mailing address of the ISA/ Japanese Patent Office | Authorized officer |
|---|---|
| Facsimile No. | Telephone No. |

Form PCT/ISA/210 (second sheet) (July 1992)